# EUROPEAN PATENT SPECIFICATION

(11) **EP 2 314 727 B1**
(45) Date of publication and mention of the grant of the patent: **23.03.2016**
(21) Application number: 10179689.4
(22) Date of filing: 24.09.2010
(51) Int. Cl.: C22C 19/05, C30B 29/52

(54) **Nickle-based superalloys and articles**
Nickelbasierte Superlegierungen und Artikel
Superalliages à base de nickel et articles

(30) Priority: 30.09.2009 US 570861
(43) Date of publication of application: 27.04.2011
(73) Proprietor: General Electric Company, Schenectady, NY 12345 (US)
(72) Inventor: Suzuki, Akane, Clifton Park, NY 12065 (US); Gigliotti, JR., Michael Francis Xavier, Scotia, NY 12302 (US); Huang, Shyh-Chin, Latham, NY 12110 (US); Subramanian, Pazhayannur Ramanathan, Niskayuna, NY 12309 (US)
(74) Representative: Illingworth-Law, William Illingworth

(56) References cited:
- EP-A2- 2 218 798
- WO-A1-2009/032579
- WO-A1-2009/085420
- FR-A1- 2 220 589
- FR-A1- 2 478 128
- JP-A- 2000 144 289
- US-A1- 2002 164 263

## Description

### BACKGROUND

The present disclosure relates to nickel-based alloys, articles based thereupon, and methods of making the articles.

Gas turbine engines operate in extreme environments, exposing the engine components, especially those in the turbine section, to high operating temperatures and stresses. In order for the turbine components to endure these conditions, they are necessarily manufactured from a material capable of withstanding these severe conditions. Superalloys have been used in these demanding applications because they maintain their strength at up to 90% of their melting temperature and have excellent environmental resistance. Nickel-based superalloys, in particular, have been used extensively throughout gas turbine engines, e.g., in turbine blade, nozzle, and shroud applications. However, designs for improved gas turbine engine performance require alloys with even higher temperature capability.

Single crystal (SC) nickel based superalloys may be divided into four generations based on similarities in alloy composition and performance. A defining characteristic of the first generation of SC superalloys is the absence of the alloying element rhenium (Re). The second generation of SC superalloys, such as CMSX-4, PWA-1484 and Rene N5, all contain about 3 wt% Re, pursuant to the discovery that the addition of this amount of Re can provide about a 50°F (28°C) improvement in rupture creep capability and the accompanying fatigue benefits. Generally, third generation superalloys are characterized by inclusion of about 6 wt% Re; while fourth generation superalloys include about 6 wt % Re, as well as the alloying element ruthenium (Ru).

Currently, gas turbine engines predominantly use second-generation superalloys because of their balance of properties. However, although the alloying element Re is the most potent solid solution strengthener known for this class of superalloys; its cost, as well as its short supply have provided a strong motivation to minimize, if not eliminate, its use in the same. To date, known superalloy compositions having lower Re content have not been able to provide the properties obtainable those having at least 3 wt%, i.e., the second generation superalloys. And, because Re is so effective at strengthening Ni base superalloys, merely replacing Re with other elements typically does not provide alloys having the strength that can otherwise be provided by Re, or can degrade environmental resistance, such as oxidation and corrosion resistance.

Thus, there remains a need for nickel based superalloy that exhibits all of the desirable properties for use in gas turbine engines, e.g., creep and fatigue strength, resistance to oxidation and corrosion at elevated temperatures, , while yet minimizing, or eliminating, the use of rhenium. Desirably, the superalloy would also exhibit good castability so as to be suitable for use directionally solidified, single crystal articles. Finer primary dendrite arm spacing (PDAS) is preferred for better mechanical properties, since finer PDAS generally gives less grain defects, porosity, and better heat treatment response.

### BRIEF DESCRIPTION

There are provided herein rhenium-free, nickel-based superalloys, comprising from 5.2 wt% to 12 wt% cobalt (Co), from 4.0 wt% to 10 wt% chromium (Cr), from 0 wt% to 3.0 wt% molybdenum (Mo), from 5.0 wt% to 11 wt% tungsten (W), from 4.0 wt% to 6.5 wt% aluminum (Al), from 0 wt% to 1.5 wt% titanium (Ti), from 4.0 wt% to 8.0 wt% tantalum (Ta), from 0.7 wt% to 1.7 wt% hafnium (Hf), up to 0.5 wt% carbon (C), up to 0.1 wt% boron (B), with the remainder being nickel (Ni) and incidental impurities, and wherein Al + 0.15Ta is from 5.9 wt% to 7.7 wt%, Al + 0.15Hf is from 5.2 wt% to 6.76 wt%, and Mo + 0.52W is from 4.2 wt% to 6.5 wt%.

There are also provided herein articles comprising the superalloys. The article comprises a rhenium-free, nickel-based alloy comprising from 5.2 wt% to 12 wt% cobalt (Co), from 4.0 wt% to 10 wt% chromium (Cr), from 0 wt% to 3.0 wt% molybdenum (Mo), from 5.0 wt% to 11 wt% tungsten (W), from 4.0 wt% to 6.5 wt% aluminum (Al), from 0 wt% to 1.5 wt% titanium (Ti), from 4.0 wt% to 8.0 wt% tantalum (Ta), from 0.7 wt% to 1.7 wt% hafnium (Hf), up to 0.5 wt% carbon (C), up to 0.1 wt% boron (B), with the remainder being nickel (Ni) and incidental impurities, wherein Al + 0.15Ta is from 5.9 wt% to 7.7 wt%, Al + 0.15Hfis from 5.2 wt% to 6.76 wt%, Mo + 0.52 W is from 4.2 wt% to 6.5 wt%.

Methods for manufacturing an article are also provided herein. The method comprises casting a nickel-based alloy into a mold and solidifying the casting into a single crystal or columnar structure with the primary dendrite arm spacing within the article less than 400 µm. The nickel-based superalloy comprises from 5.2wt% to 12 wt% cobalt (Co), from 4.0 wt% to 10 wt% chromium (Cr), from 0 wt% to 3.0 wt% molybdenum (Mo), from 5.0 wt% to 11 wt% tungsten (W), from 4.0 wt% to 6.5 wt% aluminum (Al), from 0 wt% to 1.5 wt% titanium (Ti), from 4.0 wt% to 8.0 wt% tantalum (Ta), from 0.7 wt% to 1.7 wt% hafnium (Hf), up to 0.5 wt% carbon (C), up to 0.1 wt% boron (B), with the remainder being nickel (Ni) and incidental impurities, and wherein Al + 0.15Ta is from 5.9 wt% to 7.7 wt%, Al + 0.15Hf is from 5.2 wt% to 6.76 wt%, and Mo + 0.52W is from 4.2 wt% to 6.5 wt%.

### DRAWINGS

These and other features, aspects, and advantages of the present invention will become better understood when the following detailed description is read with reference to the accompanying drawings in which like characters represent like parts throughout the drawings, wherein:
FIG. 1 is a graphical representation of creep rupture life at 1093°C/3.1 kg/cm² (2000°F/20ksi) for several alloys according to embodiments described herein as compared to the conventional nickel-based alloy René N5 and an alloy MC2+ which is a modified alloy based on the conventional rhenium-free nickel-based alloy MC2 (comprising 5 wt% Co, 8 wt% Cr, 2 wt% Mo, 8 wt%, 5 wt% Al, 1.5 wt% Ti, 6 wt% Ta, with the remainder being Ni and incidental impurities) with additions of B, C and Hf;
FIG. 2 is a graphical representation of creep rupture life at 982°C/4.6 kg/cm² (1800°F/30ksi) for several alloys according to embodiments described herein as compared to the conventional nickel-based alloy René N5 and the rhenium-free nickel-based alloy MC2+; and
FIG. 3 is a graphical representation of the weight change after cyclic oxidation test at 1093°C (2000°F) for 500 cycles for several alloys according to embodiments described herein as compared to the conventional nickel-based alloy René N5 and the rhenium-free nickel-based alloy MC2+.

### DETAILED DESCRIPTION

Unless defined otherwise, technical and scientific terms used herein have the same meaning as is commonly understood by one of skill in the art to which this invention belongs. The terms "first", "second", and the like, as used herein do not denote any order, quantity, or importance, but rather are used to distinguish one element from another. Also, the terms "a" and "an" do not denote a limitation of quantity, but rather denote the presence of at least one of the referenced item, and the terms "front", "back", "bottom", and/or "top", unless otherwise noted, are merely used for convenience of description, and are not limited to any one position or spatial orientation. If ranges are disclosed, the endpoints of all ranges directed to the same component or property are inclusive and independently combinable (e.g., ranges of "up to about 25 wt.%, or, more specifically, about 5 wt.% to about 20 wt.%," is inclusive of the endpoints and all intermediate values of the ranges of "about 5 wt.% to about 25 wt.%," etc.). The modifier "about" used in connection with a quantity is inclusive of the stated value and has the meaning dictated by the context (e.g., includes the degree of error associated with measurement of the particular quantity). The term "comprising" includes "consisting of".

A rhenium-free, nickel-based alloy is provided. More specifically, the alloy comprises various levels and combinations of elements, in place of rhenium, so that cost savings are provided. Yet, articles formed from the alloys are processed in such a way as to comprise a dendritic structure further comprising fine primary dendrite arm spacing, i.e., wherein the nominal spacing between the dendrite arms is less than about 400 micrometers. As a result, the alloy can exhibit properties substantially similar to, or even improved over, those exhibited by Re-bearing alloys, and improved balance of properties over other rhenium-free, nickel-based alloys comprising the same, or similar, combinations of elements.

More specifically, the nickel-based alloys disclosed can exhibit creep rupture lives comparable to the creep rupture of life of conventional Re-bearing alloys, such as René N5 (3 wt% Re), both at 1093°C (2000°F) and 3.1 kg/cm² (20 ksi) or 982°C (1800°F) and 4.6 kg/cm² (30 ksi). Additionally, the nickel-based alloys can exhibit oxidation resistance substantially equivalent to that exhibited by conventional Re-bearing alloys, and significantly better than that exhibited by some rhenium-free alloys, such as MC2+. And, in certain embodiments, the provided nickel-based alloys exhibit improved phase stability, with minimal, or even no, topologically-close-packed (TCP) phase formation, The ability to provide substantially similar properties as provided by Re-bearing alloys with a rhenium-free alloy provides a significant cost savings.

The rhenium-free, nickel-based alloys described herein comprise various combinations and concentrations of the elements molybdenum, tungsten, aluminum, titanium, tantalum, hafnium and silicon unique to the alloys described herein. By selecting preferred levels and ratios of the amount of these elements, desired properties, similar to those exhibited by rhenium-bearing alloys can be achieved.

More particularly, levels and ratios of certain combinations of elements were selected in certain embodiments to provide, or optimize, certain desired properties. For example, in some embodiments, the combined weight % of aluminum, hafnium and silicon according to the relationship Al + 0.15 Hf (weight %) will be between 5.2 wt% to 6.76 wt%. This relationship of Al and Hf may not only provide the alloy with improved oxidation resistance, but also, can assist in avoiding formation of the undesirable insoluble eutectic gamma prime phase.

As another example, in some embodiments, the combined weight % of aluminum and tantalum, according to the relationship Al + 0.15 Ta (weight %) is from 5.9 wt% to 7.7 wt%. Such relationship of Al and Ta can assist in the strengthening of the gamma prime phase.

In some embodiments, the combined weight % of molybdenum and tungsten according to the relationship Mo + 0.52 W, is between 4.2 and 6.5. It has now been found that, by so selecting the levels of Mo + 0.52W, the solid solution strength of the gamma prime phase of the alloy can be enhanced. It has also been found that by so selecting the levels of Mo + 0.52W, e.g., so that less than 6.5 wt% is utilized in the present alloys, precipitation of topologically-close-packed (TCP) phase and formation of an insoluble eutectic gamma prime phase can be substantially avoided.

One or more of the above relationships of elements may be utilized in different embodiments of the alloys described, and which and how many to utilize can depend on the properties desirably impacted in the alloy.

Generally speaking, the alloys described herein comprise from 5.2 wt% to 12 wt% Co, from 4 wt% to 10 wt% Cr, from 0 wt% to 3.0 wt% molybdenum (Mo), from 5.0 wt% to 11 wt% tungsten (W), from 4.0 wt% to 6.5 wt% aluminum (Al), from 0 wt% to 1.5 wt% titanium (Ti), from 4.0 wt% to 8.0 wt% tantalum (Ta) and from 0.7 wt% to 1.7 wt% hafnium (Hf), up to 0.5 wt% carbon (C), up to 0.1 wt% boron (B), with the remainder being nickel (Ni) and incidental impurities.

The molybdenum content of the nickel based alloy is between 0 wt% to 3.0 wt%, and in some embodiments, from 1.0 wt% to 2.7 wt%, while in others from 1 wt% to 2.5 wt%, or from 1.5 wt% to 2.5 wt%.

The tungsten content of the nickel-based alloy is from 5.0 wt% to 11.0 wt%, or from 5.4 wt% to 10.6 wt%, or from 6 wt% to 7.5 wt%. In other embodiments, the tungsten content of the nickel-based alloy will be from 7 wt% to 9 wt%, or from 8 wt% to 9 wt%.

The aluminum content of the nickel-based alloys, is from about 4.5 wt% to 6.0 wt%, or from 4.7 wt% to 5.7 wt%. In others, the aluminum content may range from 5.0 wt% to 6.5 wt%, or from 5.5 wt% to 6.5 wt%.

The present nickel-based alloys may comprise titanium in amounts ranging from 0 wt% to 1.5 wt%, or from 0 wt% to 1.3 wt%, or from 0 wt% to 1.0 wt%, while in others, the amount of titanium can range from 0 wt% to 1.0 wt%, or from 0 wt% to 0.5 wt%.

Tantalum may be present in amounts ranging from 4.4 wt% to 7.0 wt%, or from 5 wt% to 7 wt%. In others, tantalum may be present in amounts from 5 wt% to 7.0 wt%, or from 5.0 wt% to 6.5 wt%.

Hafnium is utilized in amounts ranging from 0.7 wt% to 1.7 wt%, or from 1.0 wt% to 1.6 wt%. In other embodiments, hafnium may be present in amounts of from 0.7 wt% to 1 wt%, or from 1 wt% to 1.5 wt%.

In addition to the elements described above, the nickel-based alloys comprise cobalt and chromium. Cobalt is added in amounts of from 5.2 wt% to 12 wt%. In some embodiments, cobalt may be present in amounts from 5.5 wt% to 10 wt%, or from 6 wt% to 9.5 wt%. In other embodiments, cobalt may be present in amounts of from 8 wt% to 11 wt%, or from 9.0 wt% to 10 wt%.

Chromium is included in amounts of from 4 wt% to 10 wt%. In some embodiments, chromium may be present in amounts of from 6 wt% to 8.5 wt%, or from 6.5 wt% to 8 wt%. In other embodiments, chromium may be present in amounts of from 6 wt% to 8 wt%, or from 6.5 wt% to 7.5 wt%.

Carbon (C), boron (B), silicon (Si), germanium (Ge), yttrium (Y) and other rare earth metals may also be included in the present nickel-based alloys, if desired.

Carbon, when utilized, may generally be utilized in the nickel-based alloys described herein in amounts of less than 0.5 wt%. In some embodiments, amounts of carbon of from 0.01 wt% to 0.5 wt% may be used in the nickel-based alloys. An exemplary amount of carbon is from 0.03 wt% to 0.49 wt%.

Boron may be present in the nickel-base alloys in some embodiments in amounts of less than or equal to 0.1 wt% of the nickel-based alloy. In some embodiments, amounts of boron between 0.001 wt% and 0.09 wt% may be included in the nickel based alloys. One exemplary amount of boron useful in the nickel based alloys is from 0.004 wt% to 0.075 wt%.

If desired, silicon may be included in certain embodiments of the nickel-based alloys. If so included, amounts of silicon of from 0.05 wt% to 1 wt% are appropriate, and exemplary amounts may range from 0.1 wt% to 0.5 wt%. Yttrium, if used, may be present in amounts of from 0.01 wt% to 0.1 wt%, and exemplary amounts range from 0.03 wt% to 0.05 wt%. Appropriate amounts of germanium can range from 0 wt% to 1 wt%, with exemplary amounts thereof ranging from 0.2wt% to 0.5 wt%.

So, for example, one embodiment of the nickel-based alloys may comprise from 5.2 wt% to 12 wt% cobalt (Co), from 1.0 wt% to 10 wt% chromium (Cr), from 0 wt% to 3.0 wt% molybdenum (Mo), from 5.0 wt% to 11 wt% tungsten (W), from 4.0 wt% to 6.5 wt% aluminum (Al), from 0 wt% to 1.5 wt% titanium (Ti), from 4.0 wt% to 8.0 wt% tantalum (Ta), from 0.7 wt% to 1.7 wt% hafnium (Hf), up to 0.5 wt% carbon (C), up to 0.1 wt% boron (B), with the remainder being nickel (Ni) and incidental impurities. Such alloys will also comprise the following relationships: Al + 0.15Ta, is from 5.9 wt% to 7.7 wt%; Al + 0.15Hf is from 5.2 wt% to 6.76 wt%; and Mo + 0.52W is from 4.2 wt% to 6.5 wt%.

In such embodiments, the nickel-based alloy may desirably comprise from 5.5 wt% to 10 wt% cobalt (Co), from 6.0 wt% to 8.5 wt% chromium (Cr), from 0 wt% to 3.0 wt% molybdenum (Mo), from 5.4 wt% to 10.6 wt% tungsten (W), from 4.5 wt% to 6.0 wt% aluminum (Al), from 0 wt% to 1.3 wt% titanium (Ti), from 4.4 wt% to 7.0 wt% tantalum (Ta), and from 0.7 wt% to 1.7 wt% hafnium (Hf). Or, in other embodiments, the nickel-based alloys may comprise from 6 wt% to 9.5 wt% cobalt (Co), from 6 wt% to 8 wt% chromium (Cr), from 1.0 wt% to 2.7 wt% molybdenum (Mo), from 6 wt% to 7.5 wt% tungsten (W), from 4.7 wt% to 5.7 wt% aluminum (Al), from 0 wt% to 1.0 wt% titanium (Ti), from 5 wt% to 7.0 wt% tantalum (Ta), and from 1.0 wt% to 1.6 wt% hafnium (Hf).

Alloys according to the embodiment described in paragraph [0034] may also comprise from 8.0 wt% to 11 wt% cobalt (Co), from 6.0 wt% to 8.0 wt% chromium (Cr), from 1 wt% to 2.5 wt% molybdenum (Mo), from 7.0 wt% to 9.0 wt% tungsten (W), from 5.0 wt% to 6.5 wt% aluminum (Al), from 0 wt% to 1.0 wt% titanium (Ti), from 5.0 wt% to 7.0 wt% tantalum (Ta), and from 0.7 wt% to 1.7 wt% hafnium (Hf). Or, such alloys may comprise from 9.0 wt% to 10 wt% cobalt (Co), from 6.5 wt% to 7.5 wt% chromium (Cr), from 1.5 wt% to 2.5 wt% molybdenum (Mo), from 8.0 wt% to 9.0 wt% tungsten (W), from 5.5 wt% to 6.5 wt% aluminum (Al), from 0 wt% to 0.5 wt% titanium (Ti), from 5.0 wt% to 6.5 wt% tantalum (Ta), and from 1 wt% to 1.5 wt% hafnium (Hf).

The nickel-based alloys may be processed according to any existing method(s) to form components for a gas turbine engine, including, but not limited to, powder metallurgy processes (e.g., sintering, hot pressing, hot isostatic processing, hot vacuum compaction, and the like), ingot casting, followed by directional solidification, investment casting, ingot casting followed by thermo-mechanical treatment, near-net-shape casting, chemical vapor deposition, physical vapor deposition, combinations of these and the like.

In one manner of manufacturing a gas turbine airfoil from a nickel-based alloy as described, the desired components are provided in the form of a powder, particulates, either separately or as a mixture and heated to a temperature sufficient to melt the metal components, generally from 1350°C to 1600°C. The molten metal is then poured into a mold in a casting process to produce the desired shape.

As mentioned above, any casting method may be utilized, e.g., ingot casting, investment casting or near net shape casting. In embodiments wherein more complex parts are desirably produced, the molten metal may desirably be cast by an investment casting process which may generally be more suitable for the production of parts that cannot be produced by normal manufacturing techniques, such as turbine buckets, that have complex shapes, or turbine components that have to withstand high temperatures. In another embodiment, the molten metals may be cast into turbine components by an ingot casting process.

The casting may be done using gravity, pressure, inert gas or vacuum conditions. In some embodiments, casting is done in a vacuum.

After casting, the melt in the mold is directionally solidified. Directional solidification generally results in single-crystal or columnar structure, i.e., elongated grains in the direction of growth, and thus, higher creep strength for the airfoil than an equiaxed cast, and is suitable for use in some embodiments

In some embodiments, the melt may be directionally solidified in a temperature gradient provided by liquid metal, for example, molten tin. Liquid metal cooling method creates larger temperature gradient than conventional directional solidification method that uses radiant cooling, and provide a finer dendrite arm spacing. Finer dendrite arm spacing, in turn, can be beneficial to the mechanical properties of the alloy, as well as in the reduction of segregation within the same.

The castings comprising the nickel-based alloy may then be typically subjected to different heat treatments in order to optimize the strength as well as to increase creep resistance. In some embodiments, the castings are desirably solution heat treated at a temperature between the solidus and gamma prime solvus temperatures. Solidus is a temperature at which alloy starts melting during heating, or finishes solidification during cooling from liquid phase. Gamma prime solvus is a temperature at which gamma prime phase completely dissolves into gamma matrix phase during heating, or starts precipitating in gamma matrix phase during cooling. Such heat treatments generally reduce the presence of segregation. After solution heat treatments, alloys are heat treated below gamma prime solvus temperature to form gamma prime precipitates.

The nickel-based alloys described herein may thus be processed into a variety of airfoils for large gas turbine engines. Because the preferred levels and ratios of elements are selected in the alloys, they and the articles and gas turbine engine components made therefrom exhibit improved high temperature strength, as well as improved oxidation resistance. Further, high gradient casting, may be used in some embodiments to provide fine dendrite arm spacing, so that further improvements in mechanical properties can be seen. Examples of components or articles suitably formed from the alloys described herein include, but are not limited to buckets (or blades), nonrotating nozzles (or vanes), shrouds, combustors, and the like. Components/articles thought to find particular benefit in being formed form the alloys described herein include nozzles and buckets.

The following examples, which are meant to be exemplary and nonlimiting, illustrate compositions and methods of manufacturing some of the various embodiments of the nickel-based alloys.

### Example 1

This example was undertaken to demonstrate the improvement in properties that can be seen nickel-based alloys according to embodiments described herein and not comprising rhenium, as compared to a conventional nickel-based alloy comprising rhenium, René N5, and a modified nickel-based rhenium-free alloy, MC2+, based on MC2 (comprising 5 wt% Co, 8 wt% Cr, 2 wt% Mo, 8 wt%, 5 wt% Al, 1.5 wt% Ti, 6 wt% Ta, with the remainder being Ni and incidental impurities) where carbon, boron and hafnium were added to the original composition. The samples having the comparative composition as well as those according to embodiments of the invention described herein are shown in Table 1, below.

**TABLE 1**

| **Composition (wt%)** | | | | | | | | | | | | |
|---|---|---|---|---|---|---|---|---|---|---|---|---|
| Alloy | Mo | W | Ta | Hf | Co | Cr | Al | Ti | C | B | Re | Ni |
| René N5 | 1.5 | 5 | 6.5 | 0.15 | 7.5 | 7 | 6.2 | 0 | 0.05 | 0.004 | 3 | Bal |
| MC2+ | 2.0 | 8.0 | 6.0 | 0.15 | 5.0 | 8.0 | 5.0 | 1.5 | 0.05 | 0.004 | 0 | Bal |
| Alloy 13 | 1.9 | 8.5 | 5.8 | 1.27 | 9.7 | 6.7 | 5.9 | 0.2 | 0.05 | 0.004 | 0 | Bal |
| Alloy 14 | 2.6 | 6.0 | 5.2 | 1.50 | 9.4 | 7.9 | 5.6 | 0.8 | 0.05 | 0.004 | 0 | Bal |

The samples were prepared by taking the various components thereof and heating them to a temperature of 1500~1550°C. The molten alloys were poured into a ceramic mold and directionally solidified into single-crystal form via high gradient casting using the liquid metal cooling method, wherein the alloys were directionally solidified in a temperature gradient provided by a molten tin bath. Liquid metal cooling method creates larger temperature gradient than conventional directional solidification method that uses radiant cooling, and provide a finer dendrite arm spacing.

The primary dendrite arm spacing was between about 170 µm and 260 µm. In each alloy, a two phase gamma plus gamma prime microstructure was achieved by solution treatment at temperatures between the solidus and solvus temperatures, followed by aging treatment at 1100°C and stabilization treatment at 900°C. The solution treatment temperatures were between 1250°C and 1310°C, and alloys were hold at the temperature for 6 to 10 hours, followed by air cool. Aging treatment was conducted at 1100°C for 4 hours, followed by air cool. Stabilization treatment was conducted at 900°C for 24 hours, followed by air cool.

The samples were then subjected to creep testing and cyclic oxidation testing. More specifically, for the creep testing the samples were cut into cylindrical dog-bone type creep sample with a total length of 3.48 cm (1.37 inches) and the gauge diameter of about 0.254 cm (0.1 inch). The testing was conducted in a tensile testing machine at a temperature of 1093°C (2000°F) under a stress of 3.1 kg/cm² (20 kilograms per square inch (ksi)), and again at a temperature of 982°C (1800°F) under a stress of 4.6 kg/cm² (30 ksi). The time taken to rupture was measured and recorded as a function of the samples ability to display creep resistance.

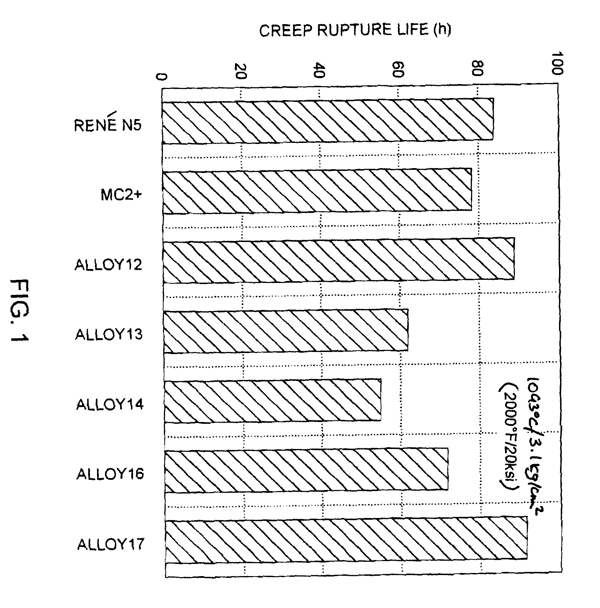

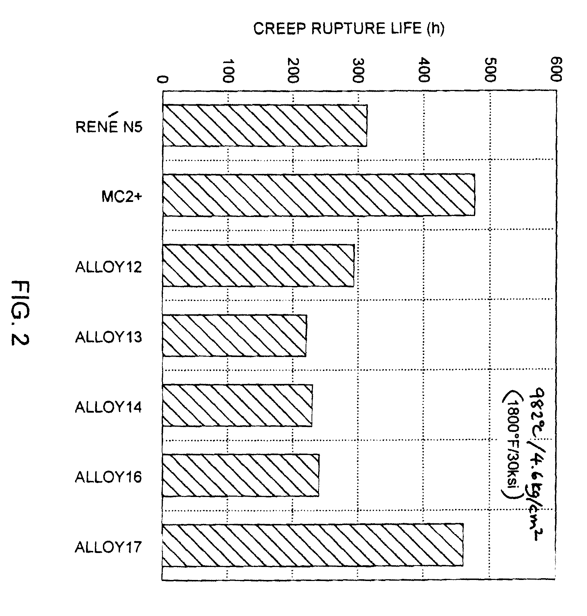

The results of the creep tests are shown in FIG. 1 (1093°C/3.1 kg/cm² ) (2000°F/20 ksi) and FIG. 2 (982°C/4.6 kg/cm²) (1800 F/30 ksi). The creep rupture lives of Alloy 13 and Alloy 14 are comparable to the rhenium-bearing single-crystal superalloy René N5.

For the cyclic oxidation tests, cylindrical specimens 2.29cm (0.9") long and 0.43 cm (0.17 in) diameter were used. Cyclic oxidation tests were conducted with a cycle consists of holding samples 1093°C (2000°F) for 50min and cooling samples to room temperature for 10 min. Tests were completed at 500 cycles. Samples were weighed at various intervals to monitor the weight change due to oxide formation.

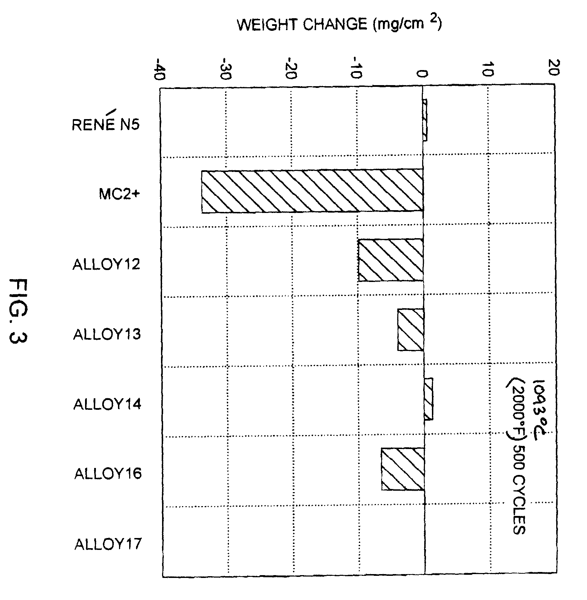

The results of the cyclic oxidation test are shown in FIG. 3. As shown, Alloy 14 (comprising 2.6 wt% molybdenum, 6.0 wt% tungsten, 5.2 wt% tantalum and 1.5 wt% hafnium) did not show any weight loss after 500 hours of exposure, indicating oxidation resistance at least on the order of that exhibited by René N5. Alloy 13 showed significantly smaller weight loss compared to that of rhenium-free alloy MC2+.

## Claims

1. A rhenium-free, nickel-based alloy comprising from 5.2 wt% to 12 wt% cobalt (Co), from 4.0 wt% to 10 wt% chromium (Cr), from 0 wt% to 3.0 wt% molybdenum (Mo), from 5.0 wt% to 11 wt% tungsten (W), from 4.0 wt% to 6.5 wt% aluminum (Al), from 0 wt% to 1.5 wt% titanium (Ti), from 4.0 wt% to 8.0 wt% tantalum (Ta), from 0.7 wt% to 1.7 wt% hafnium (Hf), up to 0.5 wt% carbon (C), up to 0.1 wt% boron (B), up to 1 wt% silicon (Si), up to 1 wt% germanium (Ge) and up to 0.1 wt% yttrium (Y), with the remainder being nickel (Ni) and incidental impurities, and wherein:
Al + 0.15Ta is from 5.9 wt% to 7.7 wt%;
Al + 0.15Hf is from 5.2 wt% to 6.76 wt%; and
Mo + 0.52W is from 4.2 wt% to 6.5 wt%.

2. The nickel-based alloy of claim 1, comprising from 5.5 wt% to 10 wt% cobalt (Co), from 6.0 wt% to 8.5 wt% chromium (Cr), from 0 wt% to 3.0 wt% molybdenum (Mo), from 5.4 wt% to 10.6 wt% tungsten (W), from 4.5 wt% to 6.0 wt% aluminum (Al), from 0 wt% to 1.3 wt% titanium (Ti), from 4.4 wt% to 7.0 wt% tantalum (Ta), and from 0.7 wt% to 1.7 wt% hafnium (Hf).

3. The nickel-based alloy of claim 1 or claim 2, comprising from 6 wt% to 9.5 wt% cobalt (Co), from 6.5wt% to 8 wt% chromium (Cr), from 1.0 wt% to 2.7 wt% molybdenum (Mo), from 6 wt% to 7.5 wt% tungsten (W), from 4.7 wt% to 5.7 wt% aluminum (Al), from 0 wt% to 1.0 wt% titanium (Ti), from 5 wt% to 7.0 wt% tantalum (Ta), and from 1.0 wt% to 1.6 wt% hafnium (Hf).

4. The nickel-based alloy of claim 1, comprising from 8.0 wt% to 11 wt% cobalt (Co), from 6.0 wt% to 8.0 wt% chromium (Cr), from 1 wt% to 2.5 wt% molybdenum (Mo), from 7.0 wt% to 9.0 wt% tungsten (W), from 5.0 wt% to 6.5 wt% aluminum (Al), from 0 wt% to 1.0 wt% titanium (Ti), from 5.0 wt% to 7.0 wt% tantalum (Ta), and from 0.7 wt% to 1.7 wt% hafnium (Hf).

5. The nickel-based alloy of claim 3, comprising from 9.0 wt% to 10 wt% cobalt (Co), from 6.5 wt% to 7.5 wt% chromium (Cr), from 1.5 wt% to 2.5 wt% molybdenum (Mo), from 8.0 wt% to 9.0 wt% tungsten (W), from 5.5 wt% to 6.5 wt% aluminum (Al), from 0 wt% to 0.5 wt% titanium (Ti), from 5.0 wt% to 6.5 wt% tantalum (Ta), and from 1 wt% to 1.5 wt% hafnium (Hf).

6. An article, comprising a rhenium-free, nickel-based alloy of any preceding claim.

7. The article of claim 6, wherein the alloy comprises a dendritic structure.

8. The article of claim 7, wherein the dendritic structure comprises primary dendrite arms having a nominal spacing less than about 400 micrometers.

9. The article of any one of claims 6 to 8, wherein the alloy is a single crystal.

10. The article of any one of claims 6 to 9, wherein the alloy comprises a directionally solidified microstructure.

11. The article of any one of claims 6 to 10, wherein the article is a component of a gas turbine assembly.

12. The article of claim 11, wherein the article comprises a blade, vane, shroud, or combustor component.

13. A method for manufacturing an article comprising casting into a mold a rhenium-free, nickel-based alloy comprising from about rhenium-free, nickel-based alloy comprising from 5.2 wt% to 12 wt% cobalt (Co), from 4.0 wt% to 10 wt% chromium (Cr), from 0 wt% to 3.0 wt% molybdenum (Mo), from 5.0 wt% to 11 wt% tungsten (W), from 4.0 wt% to 6.5 wt% aluminum (Al), from 0 wt% to 1.5 wt% titanium (Ti), from 4.0 wt% to 8.0 wt% tantalum (Ta), from 0.7 wt% to 1.7 wt% hafnium (Hf), up to 0.5 wt% carbon (C), up to 0.1 wt% boron (B), up to 1 wt% silicon (Si), up to 1 wt% germanium (Ge) and up to 0.1 wt% yttrium (Y), with the remainder being nickel (Ni) and incidental impurities, wherein:
Al + 0.15Ta is from 5.9 wt% to 7.7 wt%;
Al + 0.15Hf is from 5.2 wt% to 6.76 wt%;
Mo + 0.52W is from 4.2 wt% to 6.5 wt%; and wherein the article is cast and directionally solidified into a single crystal form or columnar structure and so that the primary dendrite arm spacing within the article is less than 400 µm.

14. The method of claim 13, wherein the nickel-based alloy comprises the alloy of any one of claims 2 to 5.

## Patentansprüche

1. Rhenium-freie Nickelbasislegierung, welche zwischen 5,2 Gew.% und 12 Gew.% Cobalt (Co), zwischen 4,0 Gew.% und 10 Gew.% Chrom (Cr), zwischen 0 Gew.% und 3,0 Gew.% Molybdän (Mo), zwischen 5,0 Gew.% und 11 Gew.% Wolfram (W), zwischen 4,0 Gew.% und 6,5 Gew.% Aluminium (Al), zwischen 0 Gew.% und 1,5 Gew.% % Titan (Ti), zwischen 4,0 Gew. % und 8,0 Gew.% Tantal (Ta), zwischen 0,7 Gew.% und 1,7 Gew.% Hafnium (Hf), bis zu 0,5 Gew.% Kohlenstoff (C), bis zu 0,1 Gew.% Bor (B), bis zu 1 Gew.% Silicium (Si), bis zu 1 Gew.% Germanium (Ge) und bis zu 0,1 Gew.% Yttrium (Y) umfasst, wobei der Rest Nickel (Ni) und zufällige Verunreinigungen sind, und wobei:
Al + 0,15 Ta zwischen 5,9 Gew.% und 7,7 Gew.% beträgt;
Al + 0,15 Hf zwischen 5,2 Gew.% und 6,76 Gew.% beträgt; und
Mo + 0,52 W zwischen 4,2 Gew.% und 6,5 Gew.% beträgt.

2. Nickelbasislegierung nach Anspruch 1, welche zwischen 5,5 Gew.% und 10 Gew.% Cobalt (Co), zwischen 6,0 Gew.% und 8,5 Gew.% Chrom (Cr), zwischen 0 Gew.% und 3,0 Gew.% Molybdän (Mo), zwischen 5,4 Gew.% und 10,6 Gew.% Wolfram (W), zwischen 4,5 Gew.% und 6,0 Gew.% Aluminium (Al), zwischen 0 Gew.% und 1,3 Gew.% Titan (Ti), zwischen 4,4 Gew.% und 7,0 Gew.% Tantal (Ta) und zwischen 0,7 Gew.% und 1,7 Gew.% Hafnium (Hf) umfasst.

3. Nickelbasislegierung nach Anspruch 1 oder 2, welche zwischen 6 Gew.% und 9,5 Gew.% Cobalt (Co), zwischen 6,5 Gew.% und 8 Gew.% Chrom (Cr), zwischen 1,0 Gew.% und 2,7 Gew.% Molybdän (Mo), zwischen 6 Gew.% und 7,5 Gew.% Wolfram (W), zwischen 4,7 Gew.% und 5,7 Gew.% Aluminium (Al), zwischen 0 Gew.% und 1,0 Gew.% Titan (Ti), zwischen 5 Gew.% und 7,0 Gew.% Tantal (Ta) und zwischen 1,0 Gew.% und 1,6 Gew.% Hafnium (Hf) umfasst.

4. Nickelbasislegierung nach Anspruch 1, welche zwischen 8,0 Gew.% und 11 Gew.% Cobalt (Co), zwischen 6,0 Gew.% und 8,0 Gew.% Chrom (Cr), zwischen 1 Gew.% und 2,5 Gew.% Molybdän (Mo), zwischen 7,0 Gew.% und 9,0 Gew.% Wolfram (W), zwischen 5,0 Gew.% und 6,5 Gew.% Aluminium (Al), zwischen 0 Gew.% und 1,0 Gew.% Titan (Ti), zwischen 5,0 Gew.% und 7,0 Gew.% Tantal (Ta) und zwischen 0,7 Gew.% und 1,7 Gew.% Hafnium (Hf) umfasst.

5. Nickelbasislegierung nach Anspruch 3, welche zwischen 9,0 Gew.% und 10 Gew.% Cobalt (Co), zwischen 6,5 Gew.% und 7,5 Gew.% Chrom (Cr), zwischen 1,5 Gew.% und 2,5 Gew.% Molybdän (Mo), zwischen 8,0 Gew.% und 9,0 Gew.% Wolfram (W), zwischen 5,5 Gew.% und 6,5 Gew.% Aluminium (Al), zwischen 0 Gew.% und 0,5 Gew.% Titan (Ti), zwischen 5,0 Gew.% und 6,5 Gew.% Tantal (Ta) und zwischen 1 Gew.% und 1,5 Gew.% Hafnium (Hf) umfasst.

6. Artikel, der eine Rhenium-freie Nickelbasislegierung nach einem der vorhergehenden Ansprüche umfasst.

7. Artikel nach Anspruch 6, wobei die Legierung eine dendritische Struktur umfasst.

8. Artikel nach Anspruch 7, wobei die dendritische Struktur primäre Dendritenarme mit einem nominalen Abstand von weniger als etwa 400 Mikrometern umfasst.

9. Artikel nach einem der Ansprüche 6 bis 8, wobei die Legierung ein einzelnes Kristall ist.

10. Artikel nach einem der Ansprüche 6 bis 9, wobei die Legierung eine gerichtet erstarrte Mikrostruktur umfasst.

11. Artikel nach einem der Ansprüche 6 bis 10, wobei der Artikel eine Komponente einer Gasturbinenbaugruppe ist.

12. Artikel nach Anspruch 11, wobei der Artikel eine Laufschaufel, eine Leitschaufel, ein Deckband oder eine Brennkammerkomponente umfasst.

13. Verfahren zur Herstellung eines Artikels, welches das Gießen einer Rhenium-freien Nickelbasislegierung in eine Form umfasst, wobei die Legierung zwischen 5,2 Gew.% und 12 Gew.% Cobalt (Co), zwischen 4,0 Gew.% und 10 Gew.% Chrom (Cr), zwischen 0 Gew.% und 3,0 Gew.% Molybdän (Mo), zwischen 5,0 Gew.% und 11 Gew.% Wolfram (W), zwischen 4,0 Gew.% und 6,5 Gew.% Aluminium (Al), zwischen 0 Gew.% und 1,5 Gew.% Titan (Ti), zwischen 4,0 Gew.% und 8,0 Gew.% Tantal (Ta), zwischen 0,7 Gew.% und 1,7 Gew.% Hafnium (Hf), bis zu 0,5 Gew.% Kohlenstoff (C), bis zu 0,1 Gew.% Bor (B), bis zu 1 Gew.% Silicium (Si), bis zu 1 Gew.% Germanium (Ge) und bis zu 0,1 Gew.% Yttrium (Y) umfasst, wobei der Rest Nickel (Ni) und zufällige Verunreinigungen sind, wobei:
Al + 0,15 Ta zwischen 5,9 Gew.% und 7,7 Gew.% beträgt;
Al + 0,15 Hf zwischen 5,2 Gew.% und 6,76 Gew.% beträgt; und
Mo + 0,52 W zwischen 4,2 Gew.% und 6,5 Gew.% beträgt; und wobei der Artikel gegossen wird und gerichtet in einer einzelnen Kristallform oder Säulenstruktur erstarrt, derart, dass der primäre Dendritenarmabstand innerhalb des Artikels weniger als 400 µm beträgt.

14. Verfahren nach Anspruch 13, wobei die Nickelbasislegierung die Legierung nach einem der Ansprüche 2 bis 5 umfasst.

## Revendications

1. Alliage à base de nickel sans rhénium, comprenant 5,2 % en poids à 12 % en poids de cobalt (Co), 4,0 % en poids à 10 % en poids de chrome (Cr), 0 % en poids à 3,0 % en poids de molybdène (Mo), 5,0 % en poids à 11% en poids de tungstène (W), 4,0 % en poids à 6,5 % en poids d'aluminium (Al), 0 % en poids à 1,5 % en poids de titane (Ti), 4,0 % en poids à 8,0 % en poids de tantale (Ta), 0,7 % en poids à 1,7 % en poids d'hafnium (Hf), jusqu'à 0,5 % en poids de carbone (C), jusqu'à 0,1 % en poids de bore (B), jusqu'à 1 % en poids de silicium (Si), jusqu'à 1 % en poids de germanium (Ge) et jusqu'à 0,1 % en poids d'yttrium (Y), le restant étant du nickel (Ni) et des impuretés accidentelles et dans lequel :
Al + 0,15 Ta est de 5,9 % en poids à 7,7 % en poids ;
Al + 0,15 Hf est de 5,2 % en poids à 6,76 % en poids ; et
Mo + 0,52 W est de 4,2 % en poids à 6,5 % en poids.

2. Alliage à base de nickel selon la revendication 1, comprenant 5,5 % en poids à 10 % en poids de cobalt (Co), 6,0 % en poids à 8,5 % en poids de chrome (Cr), 0 % en poids à 3,0 % en poids de molybdène (Mo), 5,4 % en poids à 10,6 % en poids de tungstène (W), 4,5 % en poids à 6,0 % en poids d'aluminium (Al), 0 % en poids à 1,3 % en poids de titane (Ti), 4,4 % en poids à 7,0 % en poids de tantale (Ta) et 0,7 % en poids à 1,7 % en poids d'hafnium (Hf).

3. Alliage à base de nickel selon la revendication 1 ou la revendication 2, comprenant 6 % en poids à 9,5 % en poids de cobalt (Co), 6,5 % en poids à 8 % en poids de chrome (Cr), 1,0 % en poids à 2,7 % en poids de molybdène (Mo), 6 % en poids à 7,5 % en poids de tungstène (W), 4,7% en poids à 5,7 % en poids d'aluminium (Al), 0 % en poids à 1,0 % en poids de titane (Ti), 5 % en poids à 7,0 % en poids de tantale (Ta) et 1,0 % en poids à 1,6 % en poids d'hafnium (Hf).

4. Alliage à base de nickel selon la revendication 1, comprenant 8,0 % en poids à 11 % en poids de cobalt (Co), 6,0 % en poids à 8,0 % en poids de chrome (Cr), 1 % en poids à 2,5 % en poids de molybdène (Mo), 7,0 % en poids à 9,0 % en poids de tungstène (W), 5,0 % en poids à 6,5 % en poids d'aluminium (Al), 0 % en poids à 1,0 % en poids de titane (Ti), 5,0 % en poids à 7,0 % en poids de tantale (Ta) et 0,7 % en poids à 1,7 % en poids d'hafnium (Hf).

5. Alliage à base de nickel selon la revendication 3, comprenant 9,0 % en poids à 10 % en poids de cobalt (Co), 6,5 % en poids à 7,5 % en poids de chrome (Cr), 1,5 % en poids à 2,5 % en poids de molybdène (Mo), 8,0 % en poids à 9,0 % en poids de tungstène (W), 5,5 % en poids à 6,5 % en poids d'aluminium (Al), 0 % en poids à 0,5 % en poids de titane (Ti), 5,0 % en poids à 6,5 % en poids de tantale (Ta) et 1 % en poids à 1,5 % en poids d'hafnium (Hf).

6. Article comprenant un alliage à base de nickel sans rhénium selon l'une quelconque des revendications précédentes.

7. Article selon la revendication 6, dans lequel l'alliage comprend une structure dendritique.

8. Article selon la revendication 7, dans lequel la structure dendritique comprend des bras de dendrites primaires ayant un espacement nominal inférieur à environ 400 micromètres.

9. Article selon l'une quelconque des revendications 6 à 8, dans lequel l'alliage est un monocristal.

10. Article selon l'une quelconque des revendications 6 à 9, dans lequel l'alliage comprend une microstructure directionnellement solidifiée.

11. Article selon l'une quelconque des revendications 6 à 10, dans lequel l'article est un composant d'un ensemble de turbine à gaz.

12. Article selon la revendication 11, dans lequel l'article comprend un composant de types pale, aube, carénage ou chambre de combustion.

13. Procédé de fabrication d'un article comprenant la coulée dans un moule d'un alliage à base de nickel sans rhénium, comprenant un alliage à base de nickel à peu près dépourvu de rhénium comprenant 5,2 % en poids à 12 % en poids de cobalt (Co), 4,0 % en poids à 10 % en poids de chrome (Cr), 0 % en poids à 3,0 % en poids de molybdène (Mo), 5,0 % en poids à 11 % en poids de tungstène (W), 4,0 % en poids à 6,5 % en poids d'aluminium (Al), 0 % en poids à 1,5 % en poids de titane (Ti), 4,0 % en poids à 8,0 % en poids de tantale (Ta), 0,7 % en poids à 1,7 % en poids d'hafnium (Hf), jusqu'à 0,5 % en poids de carbone (C), jusqu'à 0,1 % en poids de bore (B), jusqu'à 1 % en poids de silicium (Si), jusqu'à 1 % en poids de germanium (Ge) et jusqu'à 0,1 % en poids d'yttrium (Y), le restant étant du nickel (Ni) et des impuretés accidentelles, dans lequel :
Al + 0,15 Ta est de 5,9 % en poids à 7,7 % en poids ;
Al + 0,15 Hf est de 5,2 % en poids à 6,76 % en poids ; et
Mo + 0,52 W est de 4,2 % en poids à 6,5 % en poids ; et dans lequel l'article est coulé et directionnellement solidifié sous une forme monocristalline ou selon une structure colonnaire et de sorte que l'espacement des bras de dendrites primaires dans l'article soit inférieur à 400 µm.

14. Procédé selon la revendication 13, dans lequel l'alliage à base de nickel comprend l'alliage selon l'une quelconque des revendications 2 à 5.
